# FASCICULE DE BREVET EUROPEEN

(11) **EP 1 770 446 B1**
(45) Date de publication et mention de la délivrance du brevet: **29.10.2008**
(21) Numéro de dépôt: 06121636.2
(22) Date de dépôt: 02.10.2006
(51) Int. Cl.: G03F 7/42

(54) **Composition décapante aqueuse**
Wässriges Abbeizmittel
Aqueous stripping composition

(30) Priorité: 03.10.2005 FR 0510068
(43) Date de publication de la demande: 04.04.2007
(73) Titulaire: l'Industrielle de Chimie Elaborée Française (LICEF S.A.), 38280 Villette d'Anthon (FR)
(72) Inventeur: Galea, Christian, 38460, Siccieu-Carisieu-St. Julien (FR)
(74) Mandataire: Bratel, Gérard

(56) Documents cités:
- EP-A- 0 355 763
- EP-A- 0 810 272
- US-A- 5 741 368
- US-A- 6 159 915

## Description

La présente invention concerne le décapage chimique d'un support par élimination d'un ou plusieurs revêtements de diverses natures et épaisseurs. L'intérêt de l'invention est porté sur la présence majoritaire en eau de la composition décapante, ce qui lui confère entre autre un caractère non dangereux à l'usage pour les utilisateurs et l'environnement, tout en restant efficace pour ses propriétés décapantes. En effet, de part la présence majoritaire d'eau et le choix des solvants mis en jeu dans la composition, ce produit possède une très faible teneur en COV (Composés Organiques Volatils).

Les domaines d'applications de l'invention sont très variés, comme dans le secteur du bâtiment et du yatching. La composition et le procédé de l'invention ne se trouvent pas limités à ces domaines d'applications, les utilisations pouvant s'étendre à tous types d'industries, mais aussi à un usage dit « grand public » de part son caractère non dangereux et donc une absence d'étiquetage spécifique.

Dans le domaine du bâtiment et notamment en façades, les revêtements couramment rencontrés sont de nature organique et sont des peintures d'imperméabilité de plus ou moins grande épaisseur, des revêtements plastiques épais (RPE), des revêtements décoratifs du type marbre talochés ou encore des films minces acryliques ou pliolite.

La composition décapante selon l'invention est efficace sur tous les types de supports rencontrés en bâtiment et dans le domaine du grand public. Notamment les supports d'origine minérale tels que le béton, la brique, les supports polymères (type polyesters pour le domaine du yatching), ainsi que le bois et les métaux.

Outre son absence de dangerosité pour les utilisateurs et son impact réduit sur l'environnement, la composition décapante selon l'invention préserve l'intégrité du support traité et indépendant de la nature du ou des revêtements à éliminer, ce qui confère un caractère quasi universel. Elle a un caractère convivial de part l'aspect de son déchet et ne nécessite pas de rinçage à l'eau de façade.

On connaît dans l'art antérieur des compositions décapantes aqueuses. Ainsi, la demande de brevet EP 294041 décrit des compositions comprenant au moins 50% d'eau et des esters dibasiques comme agents actifs. Toutefois, ces compositions ont des propriétés décapantes nettement moins efficaces que les compositions chlorées de l'art antérieur. Leur usage est peu convivial car le revêtement se retire sous forme de boue de grattage de part le choix des agents actifs. De plus, la présence de ces agents actifs dans la composition peut porter atteinte à l'intégralité du nouveau revêtement d'où la nécessité de laver à l'eau abondement la façade après décapage.

De même, la demande de brevet WO 97/24409 décrit une composition majoritaire en eau, la matière active décapante étant essentiellement constituée de plastifiants permettant la plastification ou le ramollissement de films minces à décaper, ce qui favorise l'aspect de boue du déchet et le rinçage à grande eau de la façade afin de préserver le nouveau revêtement.

Généralement, ces compositions de l'art antérieur nécessitent après application et grattage une étape de lavage du support qui implique l'emploi de larges quantités d'eau et l'évacuation et le traitement d'effluents pollués par les restes de revêtement et de composition décapante.

La composition selon l'invention permet donc de remédier à ces inconvénients, à savoir conserver des propriétés décapantes efficaces, les rendants conviviales dans leur usage par rapport aux compositions à base de solvants organiques de l'art antérieur, respectueuses de l'intégrité du support décapé, sans aucune conséquence sur le nouveau revêtement, non dangereuses pour l'utilisateur et respectueuses de l'environnement.

La composition décapante aqueuse selon l'invention comprend une matière active décapante et au moins 50% d'eau par rapport au poids total de la composition. La matière active décapante est un mélange d'éthers de glycol et d'éthers-oxydes de formule générale (1) :
R1-O-R2 (1)
dans laquelle :
- R1 représente un radical alkyle linéaire ou ramifié en C1-C6, un cycloalkyle en C3-C6, ou un groupe aryle, ou un radical de formule R3-CO-,
- R2 et R3 représentent, indépendamment l'un de l'autre, un radical alkyle linéaire ou ramifié en C1-C6, cycloalkyle en C3-C6, ou un groupe aryle,
- les radicaux alkyles ou cycloalkyles de R1, R2 ou R3 étant éventuellement substitués par un ou plusieurs substituants choisis parmi les groupes aryles,

Par alkyle linéaire ou ramifié en C1-C6, on entend en particulier selon l'invention les radicaux méthyle, éthyle, n-propyle, i-propyle, n-butyle, i-butyle, t-butyle, pentyle et hexyle.

Par cycloalkyle ne C3-C6, on entend en particulier selon l'invention les radicaux cyclopropyle, cyclopentyle et cyclohexyle.

Par aryle, on entend en particulier selon l'invention un ou plusieurs cycles aromatiques ou hétéroaromatiques ayant 5 à 8 atomes de carbones, pouvant être accolés ou fusionnés, en particulier les radicaux: phényle, naphtyle, chromanyle, furanyle, indolyle, pyrolyle, quinolinyle et triazolyle. De préférence, le radical aryle est le phényle.

Cette composition décapante comprend majoritairement de l'eau dans une proportion préférentiellement comprise entre 50% et 80% par rapport au poids total de la composition..

Selon un mode préférentiel de réalisation de l'invention, la composition décapante comprend de 4 à 25 % d'éther de glycol par rapport au poids total de la composition.

L'éther de glycol est de préférence du PGDA (propylène glycol diacétate).

De manière avantageuse, la composition selon l'invention comprend de 4 à 25 % de d'ethers-oxydes de formule (1) par rapport au poids total de la composition.

De préférence, R1 représente un radical de formule R3-CO- dans laquelle R3 est un alkyle en C1-C3, de préférence le méthyle. R2 est alors avantageusement choisi parmi les radicaux benzyle, butyle et cyclohéxyle.

Selon un autre mode préférentiel de réalisation de l'invention, R1 est un aryle, de préférence le phényle. R2 est alors avantageusement choisi parmi les radicaux alkyle en C1-C3, de préférence le méthyle ou l'éthyle.

Selon un mode préférentiel de réalisation de l'invention, l'éther-oxyde de formule (1) est choisi parmi l'acétate de benzyle, l'acétate de butyle, l'acétate de cyclohéxyle l'anisole et le phénétole et leurs mélanges, de préférence l'acétate de benzyle.

Dans cette combinaison le rapport pondéral entre les éthers de glycols et les éthers-oxydes de formule (1) est avantageusement compris entre 2/1 et 1/2, de préférence voisin de 1/1. De préférence, la combinaison des éthers de glycols et des éthers-oxydes de formule (1) est comprise entre 8 et 40% du poids total de la composition. Le pourcentage pondéral de cette combinaison est avantageusement supérieur au pourcentage pondéral des autres constituants de la composition selon l'invention pris individuellement, à l'exception de l'eau.

Selon l'invention, la composition comprend au moins un agent émulsionnant choisi parmi les glucosides d'alcool gras, les éthers d'alkylpolyglucoside, les acides gras éthoxylés et leurs mélanges, dans une proportion variant de 0,1% 7% par rapport au poids total de la composition.

L'action de la composition peut être accrue par la présence d'un agent de diffusion. On entend, selon l'invention, par agent de diffusion, un agent qui permet la pénétration plus rapide de la composition dans le revêtement et permet ainsi d'accélérer l'action de celle-ci, suivant le revêtement à décaper. L'agent de diffusion est choisi parmi les solvants aprotiques dipolaires. De préférence chois parmi la DMSO, la NMP, la diméthyl formamide, l'acétonitrile, la N-méthyl morphine, la gamma butyrolactone, le diméthyl acétamide et leurs mélanges, variant dans une proportion de 3% à 25% par rapport au poids total de la composition.

La composition peut contenir en outre un co-solvant choisi parmi les solvants oxygénés afin d'en accroître l'efficacité sur les revêtements de type imperméabilité. Les solvants oxygénés sont choisis parmi la DAA (diacétone alcool), la MEC (méthyl éthyl cétone) et leurs mélanges dans une proportion variant de 1% à 7% de solvant oxygéné par rapport au poids total de la composition.

La composition peut comprendre également au moins un plastifiant, qui sert de co-solvant à l'association d'ingrédients actifs, choisi par les esters dibasiques choisi parmi les glutarates d'alkyle, les succinates d'alkyle et les adipates d'alkyle, ou un diméthyl ester ou un mélange de diméthyl ester ou le mélange de ceux-ci. Dans une proportion de 5% à 25% par rapport au poids total de la composition.

Selon l'invention, la composition peut se trouver soit à l'état liquide (fluide) soit sous forme de gel (visqueux). Dans ce dernier cas, elle comprendra un agent épaississant et/ou un agent gélifiant. L'épaississant est avantageusement choisi parmi les éthers cellulosiques, les alginates et les bentonites ou un mélange de ceux-ci, dans une proportion de variant de 0,2 à 4% par rapport au poids total de la composition.

Il est également possible d'introduire une charge inorganique dans la composition qui remplacerait une partie de l'eau. Cette charge serait choisie parmi le phosphite de calcium, le carbonate de calcium, l'hydroxyde de calcium, l'argile et le talc. Elle interviendrait dans une proportion de variant de 10% à 40% par rapport au poids total de la composition.

La somme totale des valeurs hautes des pourcentages pondéraux des différents constituants susceptibles d'entrer dans la composition décapante selon l'invention dépasse le nombre 100. L'homme du métier saura adapter la teneur relative des différents constituants pour les rapporter à un total de 100, étant entendu que la composition selon l'invention a une teneur pondérale en eau supérieure ou égale à 50% et qu'elle comprend une matière active décapante choisie parmi les éthers de glycol, les éthers-oxydes de formule (1) définie précédemment et leurs mélanges.

L'invention concerne également un procédé de décapage d'une surface à traiter recouverte d'un revêtement organique pour éliminer ledit revêtement organique, caractérisé en ce que l'on applique sur ledit revêtement organique une quantité appropriée de composition décapante selon l'invention, telle que définie précédemment et dans les exemples, que l'on laisse agir ladite composition décapante de manière à retirer le revêtement à l'état de lambeaux, puis en ce que l'on élimine par un moyen approprié les lambeaux de revêtement organique et la composition décapante.

La composition décapante de l'invention peut être appliquée au rouleau, à la brosse ou au pistolet. On peut la laisser agir sur une période variant en fonction du ou des revêtements à éliminer. L'homme du métier saura déterminer le temps nécessaire pour une action optimale de la composition selon l'invention, en fonction de la nature du matériau organique à éliminer et de son support, pouvant aller de quelques minutes à plusieurs heures, jusqu'à 12 heures ou plus. Il peut parfois être avantageux d'appliquer la composition selon l'invention en fin de journée, puis de la laisser agir pendant la nuit pour une élimination efficace des lambeaux du revêtement organique le lendemain matin. Dans d'autres cas, on cherchera une action plus rapide, généralement de 5 à 30 minutes.

La composition et les débris du ou des revêtements à l'état de lambeaux peuvent être grattés à la spatule (de préférence un scraper à lame) et le support ainsi décapé à nu est prêt au recouvrement.

La surface à traiter est avantageusement un mur ou un sol de bâtiment, ou bien une carène de bateau ou bien encore un objet en bois (palissade, escalier, meuble, etc).
Exemples de formulation, les pourcentages étant exprimés en poids par rapport au poids total de la composition :

| | **Formule A** | **Formule B** |
|---|---|---|
| Eau | 56% | 73,5% |
| Agent émulsionnant | 1,5% | 1,5% |
| DBE (dibasique ester) | 10% | 5% |
| DAA (diacétone alcool) | 7% | 3% |
| PGDA | 8,5% | 6% |
| Acétate de benzyle | 8% | 5% |
| DMSA (diméthylsulfoxide) | 7% | 4% |
| Epaississant | 2% | 2% |

### Exemple de mise en oeuvre sur un mur :

Appliquer une couche régulière de la composition au pistolet pneumatique ou sans air ou bien au rouleau ou à la brosse, le temps nécessaire à l'action s'établit en fonction de la nature du revêtement et de son épaisseur. La quantité de produit déposé dépend également de la nature du revêtement et de son épaisseur. Laisser agir.

Après grattage au scraper, il n'est pas nécessaire de rincer à l'eau la façade (car dans le choix des solvants, l'évaporation est suffisante pour garantir une bonne adhérence du nouveau revêtement).

La composition assure une totale innocuité sur l'ensemble des matériaux couramment rencontrés en façade, dans les conditions normales d'emploi.

Le résidu de décapage est très peu poisseux ce qui le rend facile à ramasser.

## Revendications

1. Composition décapante aqueuse comprenant une matière active décapante et au moins 50% d'eau par rapport au poids total de la composition, **caractérisée en ce que** la matière active décapante est un mélange d'éthers de glycol et d'éthers-oxydes de formule générale (1) :
R1-O-R2 (1)
dans laquelle :
- R1 représente un radical alkyle linéaire ou ramifié en C1-C6, un cycloalkyle en C3-C6, ou un groupe aryle, ou un radical de formule R3-CO-, et
- R2 et R3 représentent, indépendamment l'un de l'autre, un radical alkyle linéaire ou ramifié en C1-C6, cycloalkyle en C3-C6, ou un groupe aryle,
- les radicaux alkyles ou cycloalkyles de R1, R2 ou R3 étant éventuellement substitués par un ou plusieurs substituants choisis parmi les groupes aryles.

2. Composition selon la revendication 1, **caractérisée en ce qu'**elle comprend de 50 % à 80 % d'eau.

3. Composition selon l'une des revendications 1 ou 2, **caractérisée en ce qu'**elle comprend de 4 à 25 % d'éther de glycol par rapport au poids total de la composition.

4. Composition selon l'une des revendications 1 à 3, **caractérisée en ce que** l'éther de glycol est le PGDA.

5. Composition selon l'une des revendications 1 à 4, **caractérisée en ce qu'**elle comprend de 4 à 25 % d'éthers-oxydes de formule (1) par rapport au poids total de la composition.

6. Composition selon l'une des revendications 1 à 5, **caractérisée en ce que** R1 représente un radical de formule R3-CO- dans laquelle R3 est un alkyle en C1-C3, de préférence le méthyle.

7. Composition selon la revendication 6, **caractérisée en ce que** R2 est choisi parmi les radicaux benzyle, butyle et cyclohéxyle.

8. Composition selon l'une des revendications 1 à 5, **caractérisée en ce que** R1 est un aryle, de préférence le phényle.

9. Composition selon la revendication 8, **caractérisé en ce que** R2 est un alkyle en C1-C3, de préférence le méthyle ou l'éthyle.

10. Composition selon l'une des revendications 1 à 9, **caractérisée en ce que** l'éther-oxyde de formule (1) est choisi parmi l'acétate de benzyle, l'acétate de butyle, l'acétate de cyclohéxyle, l'anisole et le phénétole et leurs mélanges, de préférence l'acétate de benzyle.

11. Composition selon l'une des revendications 1 à 10, **caractérisée en ce qu'**elle comprend un agent de diffusion choisi parmi les solvants aprotiques dipolaires choisis parmi la DMSO, la NMP, la diméthyl formamide, l'acétonitrile, la N-méthyl morpholine, la gammabutyrolactone, le diméthyl acétamide et leurs mélanges, variant dans une proportion de 3% à 25% par rapport au poids total de la composition.

12. Composition selon l'une des revendications 1 à 11, **caractérisée en ce qu'**elle comprend en outre au moins un agent émulsionnant choisi parmi les glucosides d'alcool gras, les éthers d'alkylpolyglucoside, les acides gras éthoxylés et leurs mélanges et/ou un cosolvant choisi parmi les solvants oxygénés et/ou un plastifiant choisi parmi les esters dibasiques et/ou un épaississant et/ou un agent gélifiant et/ou une charge inorganique.

13. Composition selon l'une des revendications 1 à 12, **caractérisée en ce qu'**elle est sous une forme liquide ou sous forme de gel de type émulsion chargée ou non.

14. Procédé de décapage d'une surface à traiter recouverte d'un revêtement organique pour éliminer ledit revêtement organique, **caractérisé en ce que** l'on applique sur ledit revêtement organique une quantité appropriée de composition décapante selon l'une des revendications 1 à 13, que l'on laisse agir ladite composition décapante de manière à retirer le revêtement à l'état de lambeaux, puis **en ce que** l'on élimine par un moyen approprié les lambeaux de revêtement organique et la composition décapante.

15. Procédé selon la revendication 14, **caractérisé en ce que** la surface à traiter est un mur ou un sol de bâtiment, ou bien une carène de bateau ou bien encore un objet en bois.

## Claims

1. Aqueous stripping composition comprising an active stripping ingredient and at least 50% of water relative to the total weight of the composition, **characterized in that** the active stripping ingredient is a mixture of glycol ethers and of ether oxides of general formula (1):
R1-O-R2 (1)
in which:
- R1 represents a linear or branched C₁-C₆ alkyl radical, a C₃-C₆ cycloalkyl radical, or an aryl group, or a radical of formula R3-CO-; and
- R2 and R3 represent, independently of one another, a linear or branched C₁-C₆ alkyl radical, a C₃-C₆ cycloalkyl radical or an aryl group;
- the alkyl or cycloalkyl radicals of R1, R2 or R3 being optionally substituted by one or more substituents chosen from aryl groups.

2. Composition according to Claim 1, **characterized in that** it comprises from 50% to 80% of water.

3. Composition according to either of Claims 1 and 2, **characterized in that** it comprises from 4 to 25% of glycol ether relative to the total weight of the composition.

4. Composition according to one of Claims 1 to 3, **characterized in that** the glycol ether is PGDA.

5. Composition according to one of Claims 1 to 4, **characterized in that** it comprises from 4 to 25% of ether oxides of formula (1) relative to the total weight of the composition.

6. Composition according to one of Claims 1 to 5, **characterized in that** R1 represents a radical of formula R3-CO- in which R3 is a C₁-C₃ alkyl, preferably methyl.

7. Composition according to Claim 6, **characterized in that** R2 is chosen from benzyl, butyl and cyclohexyl radicals.

8. Composition according to one of Claims 1 to 5, **characterized in that** R1 is an aryl, preferably phenyl.

9. Composition according to Claim 8, **characterized in that** R2 is a C₁-C₃ alkyl, preferably methyl or ethyl.

10. Composition according to one of Claims 1 to 9, **characterized in that** the ether oxide of formula (1) is chosen from benzyl acetate, butyl acetate, cyclohexyl acetate, anisole and phenetole and mixtures thereof, preferably benzyl acetate.

11. Composition according to one of Claims 1 to 10, **characterized in that** it comprises a diffusion agent chosen from dipolar aprotic solvents chosen from DMSO, NMP, dimethylformamide, acetonitrile, N-methylmorpholine, gamma-butyrolactone, dimethylacetamide and mixtures thereof, varying in a proportion from 3% to 25% relative to the total weight of the composition.

12. Composition according to one of Claims 1 to 11, **characterized in that** it additionally comprises at least one emulsifier chosen from fatty alcohol glucosides, alkyl polyglucoside ethers, ethoxylated fatty acids and mixtures thereof and/or a cosolvent chosen from oxygenated solvents and/or a plasticizer chosen from dibasic esters and/or a thickener and/or a gelling agent and/or an inorganic filler.

13. Composition according to one of Claims 1 to 12, **characterized in that** it is in a liquid form or in the form of a filled or unfilled emulsion-type gel.

14. Method of stripping a surface to be treated, which is covered with an organic coating, in order to strip off said organic coating, **characterized in that** a suitable amount of stripping composition according to one of Claims 1 to 13 is applied to said organic coating, that said stripping composition is left to act so as to remove the coating in the form of strips, then in that the strips of organic coating and the stripping composition are removed by a suitable means.

15. Method according to Claim 14, **characterized in that** the surface to be treated is a wall or a floor of a building, or else a boat hull or even a wooden object.

## Patentansprüche

1. Wäßriges Abbeizmittel, enthaltend einen Abbeizwirkstoff und mindestens 50% Wasser, bezogen auf das Gesamtgewicht des Mittels, **dadurch gekennzeichnet, daß** es sich bei dem Abbeizwirkstoff um eine Mischung von Glykolethern und Ethern der allgemeinen Formel (1):
R1-O-R2 (1)
worin:
- R1 für einen linearen oder verzweigten C1-C6-Alkylrest, einen C3-C6-Cycloalkylrest, eine Arylgruppe oder einen Rest der Formel R3-CO-steht und
- R2 und R3 unabhängig voneinander für einen linearen oder verzweigten C1-C6-Alkylrest, einen C3-C6-Cycloalkylrest oder eine Arylgruppe stehen,
- wobei die Alkyl- und Cycloalkylreste von R1, R2 und R3 gegebenenfalls durch einen oder mehrere unter Arylgruppen ausgewählte Substituenten substituiert sind, handelt.

2. Mittel nach Anspruch 1, **dadurch gekennzeichnet, daß** es 50 bis 80% Wasser enthält.

3. Mittel nach einem der Ansprüche 1 oder 2, **dadurch gekennzeichnet, daß** es 4 bis 25% Glykolether, bezogen auf das Gesamtgewicht des Mittels, enthält.

4. Mittel nach einem der Ansprüche 1 bis 3, **dadurch gekennzeichnet, daß** es sich bei dem Glykolether um PGDA handelt.

5. Mittel nach einem der Ansprüche 1 bis 4, **dadurch gekennzeichnet, daß** es 4 bis 25% Ether der Formel (1), bezogen auf das Gesamtgewicht des Mittels, enthält.

6. Mittel nach einem der Ansprüche 1 bis 5, **dadurch gekennzeichnet, daß** R1 für einen Rest der Formel R3-CO-, worin R3 einen C1-C3-Alkylrest, vorzugsweise Methyl, bedeutet, steht.

7. Mittel nach Anspruch 6, **dadurch gekennzeichnet, daß** R2 unter Benzyl-, Butyl- und Cyclohexylresten ausgewählt ist.

8. Mittel nach einem der Ansprüche 1 bis 5, **dadurch gekennzeichnet, daß** R1 für eine Arylgruppe, vorzugsweise Phenyl, steht.

9. Mittel nach Anspruch 8, **dadurch gekennzeichnet, daß** R2 für einen C1-C3-Alkylrest, vorzugsweise Methyl oder Ethyl, steht.

10. Mittel nach einem der Ansprüche 1 bis 9, **dadurch gekennzeichnet, daß** der Ether der Formel (1) unter Essigsäurebenzylester, Essigsäurebutylester, Essigsäurecyclohexylester, Anisol und Phenetol und Mischungen davon, vorzugsweise Essigsäurebenzylester, ausgewählt ist.

11. Mittel nach einem der Ansprüche 1 bis 10, **dadurch gekennzeichnet, daß** es ein Diffundiermittel, das unter dipolaren aprotischen Lösungsmitteln, die unter DMSO, NMP, Dimethylformamid, Acetonitril, N-Methylmorpholin, gamma-Butyrolacton, Dimethylacetamid und Mischungen davon ausgewählt sind, ausgewählt ist, in einem Anteil von 3 bis 25%, bezogen auf das Gesamtgewicht des Mittels, enthält.

12. Mittel nach einem der Ansprüche 1 bis 11, **dadurch gekennzeichnet, daß** es außerdem einen Emulgator, der unter Fettalkoholglucosiden, Alkylpolyglucosidethern, ethoxylierten Fettsäuren und Mischungen davon ausgewählt ist, und/oder ein Cosolvens, das unter sauerstoffhaltigen Lösungsmitteln ausgewählt ist, und/oder einen Weichmacher, der unter zweibasigen Estern ausgewählt ist, und/oder einen Verdicker und/oder einen Gelbildner und/oder einen anorganischen Füllstoff enthält.

13. Mittel nach einem der Ansprüche 1 bis 12, **dadurch gekennzeichnet, daß** es in flüssiger Form oder in Form eines Gels vom Typ geladene oder ungeladene Emulsion vorliegt.

14. Verfahren zum Abbeizen einer zu behandelnden Oberfläche, die mit einem organischen Überzug bedeckt ist, zur Entfernung des organischen Überzugs, **dadurch gekennzeichnet, daß** man auf den organischen Überzug eine geeignete Menge des Abbeizmittels nach einem der Ansprüche 1 bis 13 aufbringt, das Abbeizmittel so wirken läßt, daß sich der Überzug in Form von Fetzen ablöst, und dann die Fetzen des organischen Überzugs und das Abbeizmittel mit einem geeigneten Mittel entfernt.

15. Verfahren nach Anspruch 14, **dadurch gekennzeichnet, daß** es sich bei der zu behandelnden Oberfläche um eine Gebäudewand oder einen Gebäudeboden, einen Schiffsboden oder einen Holzgegenstand handelt.
